Europäisches Patentamt

European Patent Office

Office européen des brevets

(11) Numéro de publication: **0 644 434 A1**

(12) **DEMANDE DE BREVET EUROPEEN**

(21) Numéro de dépôt: **93440076.3**

(22) Date de dépôt: **16.09.93**

(51) Int. Cl.6: **G01R 33/24**, G01R 33/3873, G01R 33/3875

(43) Date de publication de la demande:
**22.03.95 Bulletin 95/12**

(84) Etats contractants désignés:
**BE CH DE GB LI**

(71) Demandeur: **SADIS BRUKER SPECTROSPIN, SOCIETE ANONYME DE DIFFUSION DE L'INSTRUMENTATION SCIENTIFIOUE BRUKER SPECTROSPIN**
**34, rue de l'Industrie**
**F-67160 Wissembourg (FR)**

(72) Inventeur: **Zwiebel, René**
**2 rue des Roses**
**F-67160 Riedseltz (FR)**
Inventeur: **Fritz, Rémy**
**5 rue du Faubourg**
**F-67630 Lauterbourg (FR)**

(74) Mandataire: **Nuss, Pierre et al**
**10, rue Jacques Kablé**
**F-67080 Strasbourg Cédex (FR)**

(54) **Procédé de mesure et d'ajustement des gradients d'un appareil à résonance magnétique nucléaire et dispositif correspondant.**

(57) La présente invention a pour objet un procédé de mesure et d'ajustement des gradients d'un appareil à RMN et le dispositif correspondant.

Procédé caractérisé en ce qu'il consiste, essentiellement, à mettre en place sélectivement un ensemble d'échantillons d'analyse ou à sélectionner de tels échantillons déjà installés, aux endroits où l'action de la bobine de correction (Bi) à ajuster de la pièce ferromagnétique correspondante, pour un gradient de champ donné, est, d'une part, prédominante et, d'autre part, symétrique et/ou opposée, à alimenter sélectivement ladite bobine de correction (Bi) à ajuster, ainsi que, le cas échéant, les bobines de correction déjà ajustées, à relever le signal RMN desdits échantillons d'analyse, à visualiser ledit signal, après transformation, dans le domaine des fréquences, à régler le courant d'alimentation de la bobine de correction (Bi) à ajuster, en observant, en temps réel, l'évolution du spectre fréquentiel du signal RMN desdits échantillons d'analyse, jusqu'à obtenir une configuration du spectre correspondant à une compensation totale du gradient influencé, et, enfin, à effectuer ces opérations pour l'ensemble des bobines de correction, selon un ordre prédéterminé.

Fig.1

La présente invention concerne le domaine du réglage de certains paramètres influençant l'homogénéité du champ magnétique d'un appareil à résonance magnétique nucléaire, notamment au niveau de la zone d'analyse, et a pour objet un procédé de mesure et d'ajustement des gradients de champ d'un appareil à Résonance Magnétique Nucléaire (RMN) ainsi qu'un dispositif pour la mise en oeuvre de ce procédé.

Les aimants principaux des appareils à RMN présentent généralement différentes imperfections structurelles ou de fabrication résultant en des inhomogénéités du champ magnétique, sous forme de gradients, générés par ledit aimant.

Actuellement, une pluralité de petites bobines, appelées bobines de correction, et/ou des pièces ferromagnétiques correspondantes disposées dans le voisinage immédiat de la bobine de détection ou montées directement dans la structure de l'aimant principal, permettent de corriger ces inhomogénéités du champ magnétique, en fonctionnant comme de petits électro-aimants. Ces bobines de correction peuvent soit être montées dans la structure de l'aimant principal d'un appareil à RMN, soit être disposées à proximité et autour de la bobine de détection.

Il est néanmoins nécessaire de positionner ces bobines de correction ou pièces ferromagnétiques de telle manière que leur action soit effective dans toutes les directions et qu'elles puissent ainsi corriger tous les défauts résultant de la fabrication dudit aimant.

Le nombre de bobines ou de pièces utilisées dépend essentiellement de l'importance du champ magnétique et de la zone ou du volume qui doit être homogénéisé.

Une autre nécessité, en vue d'obtenir une homogénéité permettant des résolutions de l'ordre de quelques centièmes de Hertz, consiste à régler l'action de chaque bobine de correction ou de chaque pièce ferromagnétique de manière à annuler exactement le gradient de champ qu'elle est susceptible d'influencer.

Or, les méthodes actuelles de réglage, basées généralement sur l'allure du signal de résonance magnétique nucléaire ou sur le signal d'asservissement du champ magnétique, ne permettent pas de savoir quel gradient doit être compensé ni quelle doit être l'intensité de cette compensation.

Le réglage de bobines ou la mise en place et le positionnement des pièces ferromagnétiques par l'intermédiaire de ces méthodes nécessite souvent plusieurs jours de travail et l'expérience d'un technicien aguerri.

Il existe également des procédés de mesure point par point permettant d'établir une représentation graphique du champ magnétique, et donc d'identifier les gradients à corriger.

Néanmoins, la réalisation de cette représentation constitue une opération fastidieuse, nécessitant au moins une journée de travail pour une personne spécialisée.

Le problème posé à la présente invention consiste par conséquent à concevoir un procédé et un dispositif permettant, de manière simple et méthodique, d'effectuer rapidement l'ajustement de l'ensemble des gradients pouvant être compensés par les bobines de correction ou des pièces ferromagnétiques correspondantes, ce pour les appareils à RMN à aimants verticaux et horizontaux et par des personnes éventuellement non spécialistes.

Ce problème est précisément résolu grâce au procédé de mesure et d'ajustement des gradients d'un appareil à RMN, en vue de l'obtention d'un volume d'analyse magnétiquement homogène, caractérisé en ce qu'il consiste, essentiellement, à mettre en place sélectivement un ensemble d'échantillons d'analyse ou à sélectionner de tels échantillons déjà installés, aux endroits où l'action de la bobine de correction à ajuster ou de la pièce ferromagnétique correspondante, pour un gradient de champ donné, est, d'une part, prédominante et, d'autre part, symétrique et/ou opposée, à alimenter sélectivement ladite bobine de correction à ajuster, ainsi que, le cas échéant, les bobines de correction déjà ajustées, ou à mettre en place la pièce ferromagnétique correspondante, à relever le signal RMN desdits échantillons d'analyse, à visualiser ledit signal, après transformation, dans le domaine des fréquences, à régler le courant d'alimentation de la bobine de correction à ajuster ou à faire varier le nombre d'éléments constitutifs et/ou le positionnement de la pièce ferromagnétique correspondante, en observant, en temps réel, l'évolution du spectre fréquentiel du signal RMN desdits échantillons d'analyse, jusqu'à obtenir une configuration du spectre correspondant à une compensation totale du gradient influencé par ladite bobine de correction ou ladite pièce ferromagnétique, et, enfin, à effectuer ces opérations pour l'ensemble des bobines de correction ou des pièces ferromagnétiques correspondantes, selon un ordre prédéterminé fonction notamment de la configuration du volume d'analyse magnétiquement homogène à obtenir.

L'invention a également pour objet un dispositif de mesure et de réglage pour la mise en oeuvre du procédé précité, caractérisé en ce qu'il est principalement constitué, d'une part, par des ensembles d'échantillons d'analyse de faible dimension, montés dans la structure d'un aimant principal d'un appareil à RMN ou mis en place à l'aide d'un porte-échantillon coopérant avec un guide de positionnement au niveau de la bobine de détection de l'appareil à RMN, d'autre part, par des unités de mesure, d'acquisition, de transformation et de visualisation du signal RMN émis par l'ensemble d'échantillons d'analyse sélectionnés et, enfin, par un module de sélection et d'alimentation réglable des bobines de correction à ajuster et un module de sélection des bobines de correction montées dans la structure de l'aimant principal.

L'invention sera mieux comprise grâce à la description ci-après, qui se rapporte à un mode de réalisation préféré, donné à titre d'exemple non limitatif, et expliqué avec référence aux dessins schématiques annexés, dans lesquels:

la figure 1 est une vue schématique du dispositif conforme à l'invention;

la figure 2 est une vue schématique en perspective montrant un mode de réalisation du découpage d'un volume d'analyse cylindrique;

les figures 3A à 3L représentent de manière schématique les emplacements des échantillons d'analyse en fonction des gradients à ajuster et des bobines de correction à régler;

les figures 4A et 4B représentent respectivement une vue en élévation latérale et partiellement en coupe d'un porte-échantillons et une vue en élévation latérale et en coupe d'un guide positionnement, conformes à l'invention;

les figures 5A à 5D représentent les différents types de contenants comprenant les échantillons d'analyse;

les figures 6A et 6B sont des représentations graphiques visualisant un gradient donné agissant au niveau du plan de correction central, d'une part, au moyen d'une courbe montrant la fréquence de résonance RMN en fonction de la position, et, d'autre part, au moyen d'une courbe montrant la transformé de Fourier du signal de RMN des échantillons d'analyse correspondants, ce avant et après correction dudit gradient;

les figures 7A à 7D sont des représentations graphiques du même type que celles des figures 5A et 5B, montrant les corrections successives des différents gradients agissant suivant l'axe longitudinal Z;

les figures 8A à 8D sont des représentations graphiques du même type que celles des figures 5A et 5B, montrant les phases de corrections successives de gradients donnés agissant au niveau de plans de correction autres que le plan de correction central.

Conformément à l'invention le procédé de mesure et d'ajustement des gradients consiste essentiellement à mettre en place sélectivement un ensemble d'échantillons d'analyse Ei ou à sélectionner de tels échantillons Ei déjà installés, aux endroits où l'action de la bobine de correction Bi à ajuster ou de la pièce ferromagnétique correspondante, pour un gradient de champ Gi donné, est, d'une part, prédominante et, d'autre part, symétrique et/ou opposée, à alimenter sélectivement ladite bobine de correction Bi à ajuster, ainsi que, le cas échéant, les bobines de correction déjà ajustées ou à mettre en place la pièce ferromagnétique correspondante, à relever le signal RMN desdits échantillons d'analyse Ei, à visualiser ledit signal, après transformation, dans le domaine des fréquences, à régler le courant d'alimentation de la bobine de correction Bi à ajuster, ou à faire varier le nombre d'éléments constitutifs et/ou le positionnement de la pièce ferromagnétique correspondante, en observant, en temps réel, l'évolution du spectre fréquentiel du signal RMN desdits échantillons d'analyse Ei jusqu'à obtenir une configuration du spectre correspondant à une compensation totale du gradient Gi influencé par ladite bobine de correction Bi ou ladite pièce ferromagnétique, et, enfin, à effectuer ces opérations pour l'ensemble des bobines de correction ou des pièces ferromagnétiques correspondantes, selon un ordre prédéterminé fonction notamment de la configuration du volume d'analyse V magnétiquement homogène à obtenir.

Ainsi, il est possible de rendre visible, de manière sélective chaque gradient Gi et de le compenser ou de le corriger individuellement.

Les échantillons d'analyse Ei, mis en oeuvre par groupes ou ensembles et dont le nombre et les emplacements dépendent du ou des gradients Gi à visualiser et à corriger au cours d'une opération d'ajustement, permettant, par l'intermédiaire de leur spectre RMN, de visualiser le ou les gradients Gi correspondant par la position et le nombre de pics que présente ledit spectre, ces dernières caractéristiques indiquant précisément la différence de champ magnétique entre chacun desdits échantillons d'analyse Ei mis en oeuvre simultanément pour une phase d'application du procédé.

Le gradient Gi à compenser étant reconnu par son action sur les positions relatives ou le nombre des pics présents dans le spectre RMN des différents échantillons Ei, il suffit de régler la bobine de correction Bi ou la pièce ferromagnétique correspondante afin d'obtenir la disposition mutuelle ou le nombre de pics correspondant à une correction dudit gradient Gi.

Dans le développement descriptif ci-après, le procédé conforme à l'invention sera décrit plus particulièrement dans le cadre d'une application se rapportant aux réglages de bobines de correction. Néanmoins, les différentes caractéristiques mentionnées pourront, par simple transposition, également être mises en oeuvre dans le cas d'une compensation ou d'une correction des gradients au moyen de pièces ferromagnétiques. En effet, au lieu de procéder au réglage du courant d'alimentation des bobines de correction, il y aura lieu de faire varier, pour une pièce ferromagnétique donnée, équivalente dans son action à une bobine de correction Bi, le nombre d'éléments ferromagnétiques constitutifs et/ou le positionnement de ladite pièce, agissant directement sur l'intensité, respectivement la direction, de l'action de la pièce ferromagnétique concernée.

Pour les appareils à RMN présentant les deux types de compensation des gradients, il sera préférentiellement procédé à une première compensation grossière des gradients au moyen des pièces ferromagnétiques, et ensuite à une seconde compensation, plus fine, au moyen des bobines de correction Bi.

Dans le cas d'un volume d'analyse V cylindrique, à disposition verticale ou horizontale, on pourra avantageusement effectuer, comme le montre notamment la figure 2 des dessins annexés, un découpage dudit volume d'analyse V en tenant compte de l'emplacement des bobines de correction Bi, par l'intermédiaire d'un nombre impair de sections transversales régulièrement espacées définissant autant de plans de correction P, Pc pouvant recevoir des échantillons d'analyse Ei, le point d'intersection O du plan de correction central Pc avec l'axe longitudinal Z dudit volume d'analyse V étant confondu avec le centre d'action commun de l'ensemble des bobines de correction, de la bobine de détection 3 et de l'aimant principal 1, et les plans de correction P extrêmes délimitant longitudinalement le volume d'analyse V.

De plus, chacun dans des plans de correction P, Pc, on pourra également définir un repère octogonal X, Y dépendant directement de la disposition des bobines de correction Bi prédominantes, et alignés notamment avec les directions d'action prédominante de ces dernières.

Généralement, les appareils à RMN actuels comportent dixsept bobines de correction Bi, et la description qui va suivre portera, à titre d'exemple non limitatif, plus précisément sur la mise en oeuvre du procédé conforme à l'invention à un appareil à RMN de ce type.

Néanmoins, l'application dudit procédé à un nombre plus important ou plus restreint de bobines de correction Bi est évident pour l'homme du métier en possession des enseignements de la présente invention.

Afin de faciliter la compréhension et d'alléger l'écriture, les différents gradients Gi et les bobines de correction Bi correspondantes seront avantageusement désignés de manière similaire, avec référence au repère X, Y, Z défini précédemment, en fonction de l'emplacement, de la nature et de la direction de leur action.

Ainsi, trois groupes distinctifs de gradients Gi (ou de bobines de correction Bi) peuvent être déterminés:

- ceux agissant le long de l'axe longitudinal Z: $Z^1$, $Z^2$, $Z^3$ et $Z^4$;
- ceux agissant au niveau du plan de correction central Pc : X, Y, $X^2 - Y^2$, XY, $X^3$ et $Y^3$;
- ceux agissant de manière prédominante au niveau des plans de correction P extrêmes: ZX, ZY, $Z^2X$, $Z^2Y$, $Z(X^2 - Y^2)$ et ZXY.

Afin de pouvoir visualiser ces différents gradients Gi, mesurer leur intensité et procéder à leur ajustement par l'intermédiaire des bobines de correction Bi, en les contrôlant en temps réel, les échantillons d'analyse Ei de faible dimension, sont disposés, en fonction des bobines de correction Bi à régler, soit sur l'enveloppe du volume d'analyse V cylindrique, au niveau d'un ou de plusieurs plans de correction P, Pc et de manière régulièrement espacés, soit au niveau des points d'intersection desdits plans de correction P, Pc avec l'axe longitudinal Z.

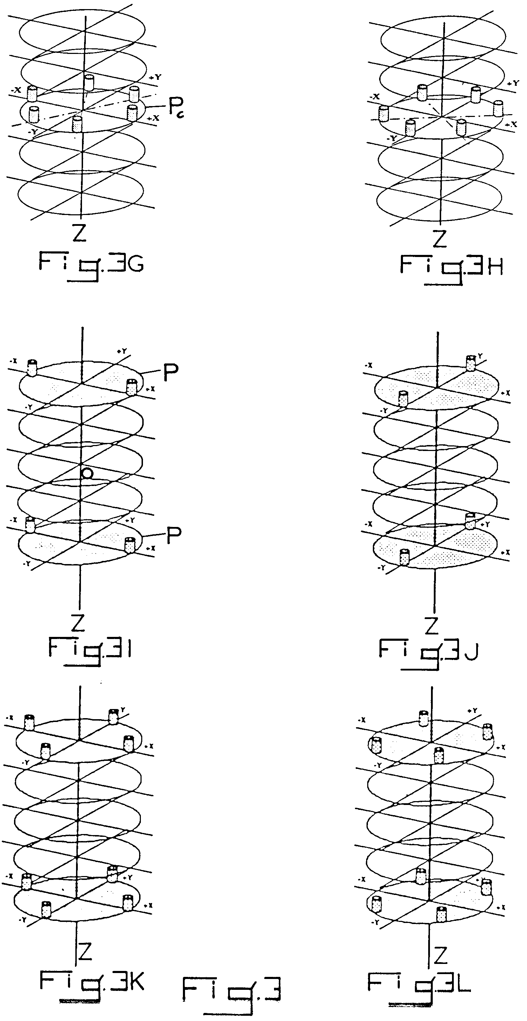

Les figures 3A à 3L des dessins annexés montrent, à titre d'exemples et en regard des gradients Gi et des bobines de correction Bi définis précédemment, de manière schématique, la disposition et la constitution des ensembles d'échantillons d'analyse Ei destinés, chacun, à permettre la visualisation et la correction d'un ou de plusieurs desdits gradients Gi. Les références desdits ensembles d'échantillons d'analyse Ei sont identiques à celles des gradients Gi dont ils autorisent la visualisation et la correction.

Conformément à une caractéristique de l'invention, le procédé de mesure des gradients Gi et d'ajustement des bobines de correction Bi consiste, préalablement à leur ajustement, à aligner précisément entre elles, deux à deux, les bobines de correction Bi, celles montées dans la structure de l'aimant principal 1 et celles disposées directement autour de la bobine de détection 3, devant agir dans la même direction, le réglage des bobines de correction montées dans la structure de l'aimant principal étant opéré avant celui des bobines de correction disposées autour de la bobine de détection 3.

En outre, du fait de l'absence d'influence des bobines de correction Bi dépendant de Z au niveau du plan de correction central Pc, il est avantageux de régler successivement d'abord les bobines de correction B(X), B(Y), B($X^2 - Y^2$), B(XY), B($X^3$) et B($Y^3$)) agissant au niveau du plan de correction central Pc, puis les bobines de correction B($Z^1$), B($Z^2$), B($Z^3$) et B($Z^4$)) agissant le long de l'axe longitudinal Z, et, enfin, les bobines de correction B(ZX), B(ZY), B($Z^2X$), B($Z^2Y$), B($Z(X^2 - Y^2)$) et B(ZXY) agissant au niveau des autres plans de correction P.

Selon un mode de réalisation préféré de l'invention, le réglage des bobines de correction Bi induisant les gradients Gi à action prédominante, est effectué prioritairement. Ainsi, B(X) sera ajustée avant B($X^2 - Y^2$) ou B(XY), de même le réglage de

$B(Z^2)$ sera antérieur à celui de $B(Z^3)$ ou $B(Z^4)$.

Néanmoins, il peut également être avantageux d'autoriser, dans un premier temps, l'existence d'un gradient $G(Z^1)$ et, le cas échéant, la bobine de correction $B(Z^1)$ dont l'action est prédominante selon l'axe longitudinal Z afin d'autoriser une visualisation et un réglage aisés des autres bobines de correction $B(Z^2, Z^3, Z^4)$ agissant selon l'axe longitudinal Z et des bobines de correction $B(ZX)$, $B(ZY)$, $B(Z^2X)$, $B(Z^2Y)$, $B(Z(X^2 - Y^2))$, $B(ZXY))$ agissant au niveau des plans de correction P autres que le plan de correction central Pc.

A titre d'exemple,s le procédé conforme à l'invention sera décrit à présent dans des cas de mise en oeuvre pratiques de réglages de certaines bobines de correction Bi, les étapes desdits réglages étant illustrées au moyen des courbes représentées aux figures 6, 7 et 8 des dessins annexés.

Les figures 6 montrent, au moyen de courbes du type : Fréquence de résonance = Courant d'alimentation de B(X) x Fonction (position), relevées au moyen de l'ensemble d'échantillons d'analyse E(X), et de leur transformées de Fourier associées, le réglage du gradient G(X).

Un gradient G(X) parfait peut se représenter par une courbe sinusoïdale dont les maxima se trouvent à + X et -X dans le plan de correction central Pc (Figure 6A).

Etant donné les positions des échantillons d'analyse E(X), la transformée de Fourier de leur signaux RMN montre, lors de la présence d'un gradient G(X), que les deux échantillons d'analyse E(X) ne résonnent pas à la même fréquence, l'importance du gradient G(X) présent étant visualisée directement par la valeur de la distance séparant les deux pics de résonance. Ainsi, le gradient G(X) est nul ou compensé lorsque les deux pics sont superposés en un pic unique d'amplitude maximale.

L'opération de réglage consiste donc à faire varier le courant d'alimentation de la bobine de correction B(X) jusqu'à regrouper les deux pics de résonance en un pic unique, de valeur maximale (Figure 6B). Ce principe reste valable pour la compensation de tous les gradients Gi.

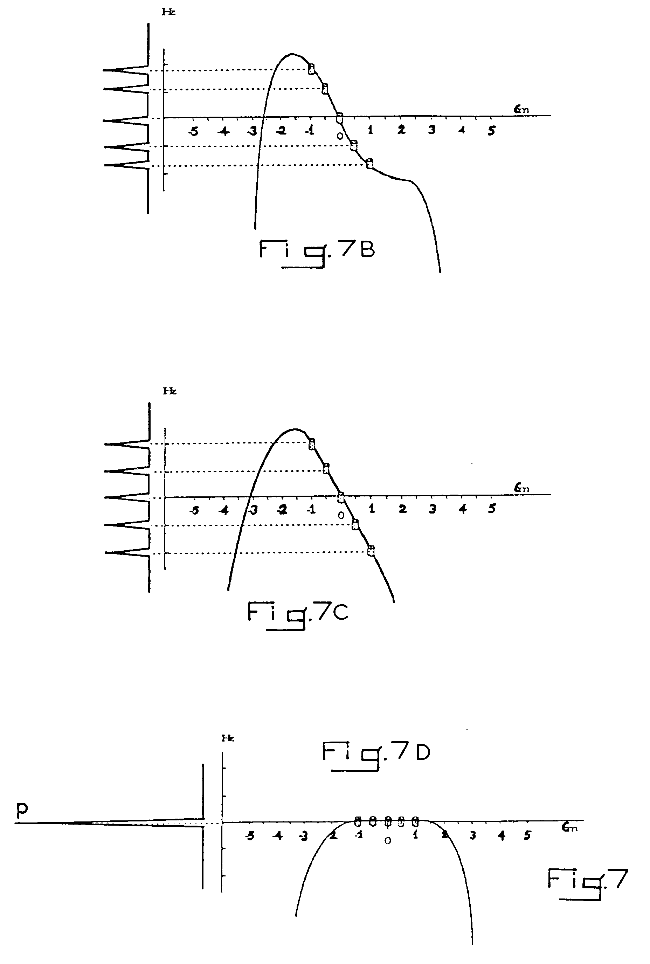

Les figures 7 montrent, au moyen de courbes du même type que celles représentées aux figures 6, mais relevées par l'intermédiaire de l'ensemble d'échantillons d'analyse $E(Z^1 - Z^2 -Z^3 -Z^4)$, le réglage des gradients $G(Z^1)$, $G(Z^2)$, $G(Z^3)$ et $G(Z^4)$.

L'opération de réglage de l'ensemble de ces gradients consiste, comme précédemment pour G(X), à superposer au moyen de la bobine de correction $B(Z^1)$ l'ensemble des pics correspondant aux fréquences de résonance des différents échantillons d'analyse utilisés dans le domaine fréquentiel (Figure 7A), ce après avoir rendu leur disposition symétrique et régulière au moyen des bobines de correction $B(Z^2)$, $B(Z^3)$ et $B(Z^4)$.

Ainsi, les ajustements des bobines de correction $B(Z^2)$ et $B(Z^4)$ permettent de rendre symétrique la disposition respectivement des pics P1 et P1' et des pics P2 et P2' par rapport au pic central P0 (comparer la figure 7B à la figure 7A).

Ensuite, le réglage de la bobine de correction $B(Z^3)$ entraîne une régularisation des intervalles (Figure 7C) et le réglage de la bobine de correction $B(Z^1)$ permet de superposer l'ensemble de ces pics en un seul pic P (Figure 7D).

En cas d'absence d'un gradient $G(Z^1)$, on peut avantageusement générer un tel gradient en déréglant volontairement la bobine de correction $B(Z^1)$, ce afin d'autoriser un réglage aisé des bobines de correction $B(Z^2)$, $B(Z^3)$ et $B(Z^4)$ par un espacement important des différents pics du spectre fréquentiel entre eux.

Il est à noter également que les gradients $G(Z^1)$ et $G(Z^2)$ peuvent être compensés indépendamment des gradients $G(Z^3)$ et $G(Z^4)$ en mettant en oeuvre l'ensemble d'échantillons d'analyse $E(Z^1 - Z^2)$ représenté à la figure 3A.

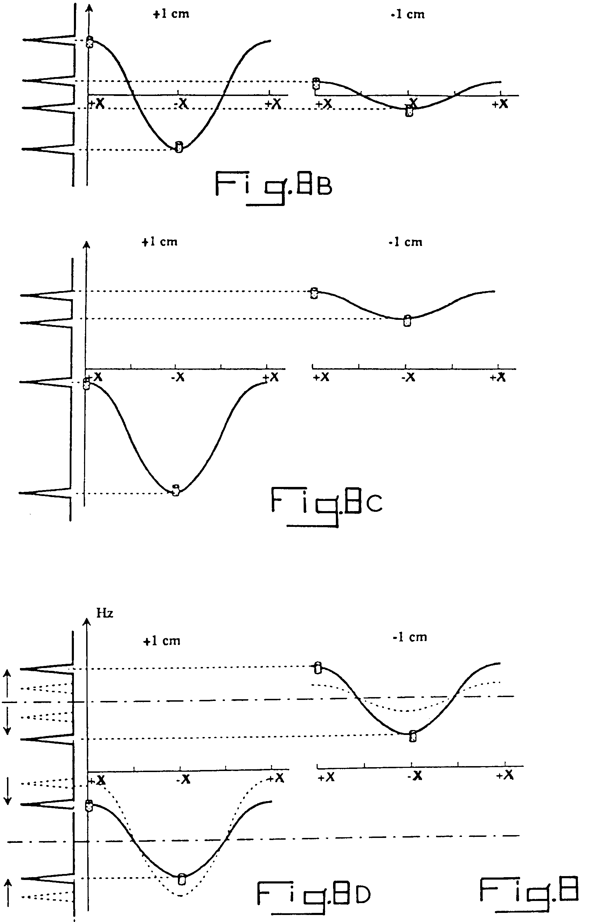

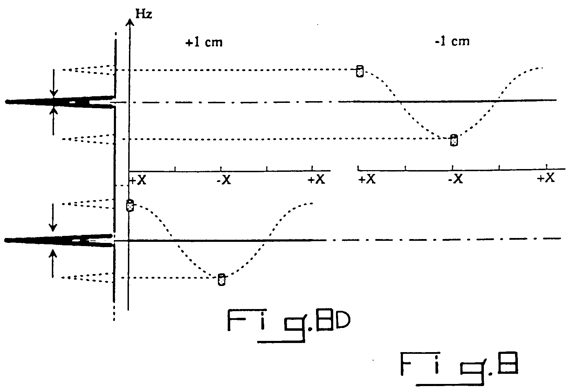

Les figures 8 montrent, d'une manière identique aux exemples précédents, le réglage des bobines de correction $B(ZX)$ et $B(Z^2X)$ par l'intermédiaire de l'ensemble d'échantillons d'analyse $E(ZX + Z^2X)$ permettant d'appréhender les gradients $G(ZX)$ et $G(Z^2X)$ à travers leur somme.

Avant de débuter l'opération de compensation proprement dite, il est nécessaire d'introduire un gradient $G(Z^1)$ ce afin de séparer les actions au niveau des plans de correction P supérieurs et inférieurs (Figure 8A: $G(ZX)$ + $G(Z^2X)$; Figure 8B: $G(Z)$ + $G(ZX)$ + $G(Z^2X)$.

Il suffit ensuite d'égaliser l'espacement des différents pics au moyen de la bobine de correction $B(ZX)$ ou $B(Z^2X)$ correspondant au gradient le plus faible (Figure 8C), puis de regrouper deux à deux lesdits pics (Fig.: 8D) au moyen de l'autre bobine de correction $B(Z^2X)$ ou $B(ZX)$, les gradients $G(ZX)$ et $(Z^2X)$ étant alors compensés.

Ces exemples donnés à titre illustratif permettent aisément à l'homme du métier d'en déduire, à l'aide des différents ensembles d'échantillons d'analyse Ei montrés aux figures 3 des dessins annexés, les étapes pratiques des réglages des autres bobines de correction Bi.

L'ensemble des caractéristiques précitées pourra, bien évidemment, également être exploité dans le cadre d'une compensation des gradients au moyen de pièces ferromagnétiques.

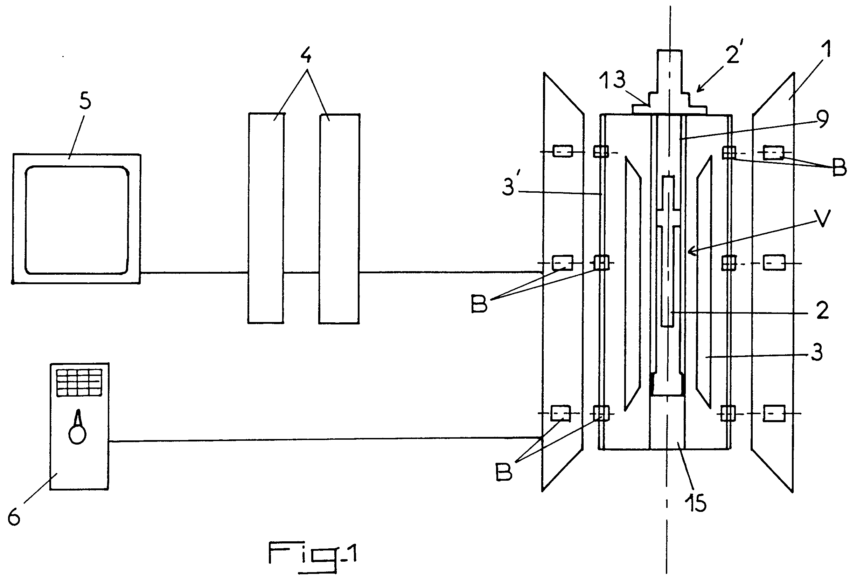

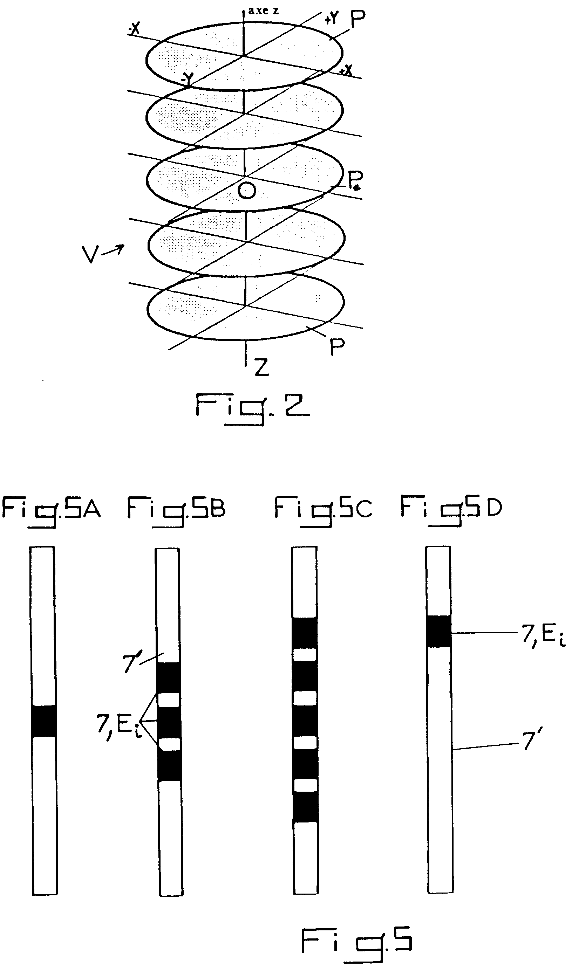

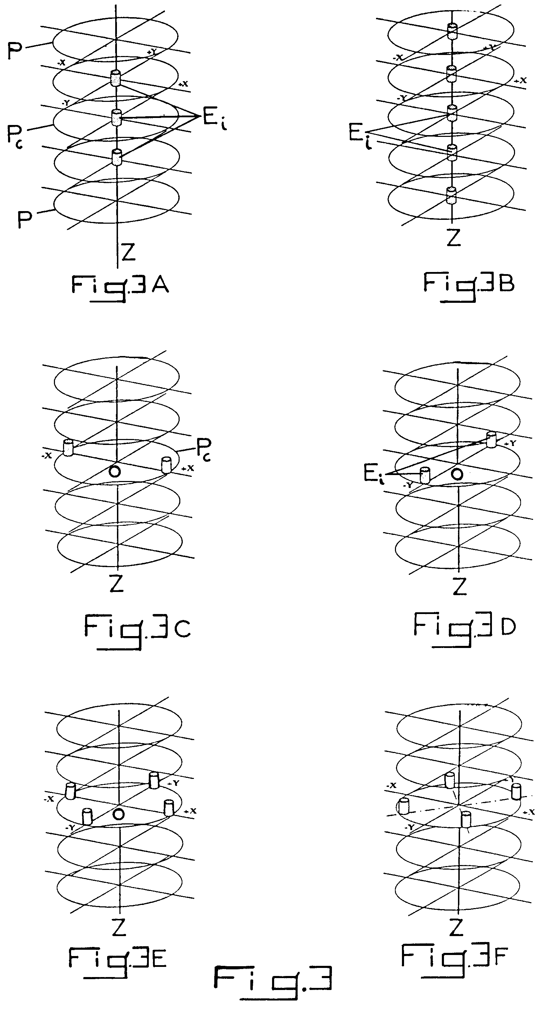

La présente invention a également pour objet un dispositif de mesure et de réglage pour la mise en oeuvre du procédé de mesure et d'ajustement décrit ci-avant, dispositif principalement constitué , d'une part, par des ensembles d'échantillons d'analyse Ei de faible dimension, montés dans la structure d'un aimant principal 1 d'un appareil à RMN ou mis en place à l'aide d'un porte-échantillons 2 coopérant avec un guide de positionnement au niveau de la bobine de détection 3 de l'appareil à RMN, d'autre part, par des unités 4, 5 de mesure, d'acquisition, de transformation et de visualisation du signal RMN émis par l'ensemble d'échantillons d'analyse Ei sélectionnés et, enfin, par un module 6 de sélection et d'alimentation réglable des bobines de correction Bi à ajuster et un module de sélection des bobines de correction montées dans la structure de l'aimant principal 1 (Fig. 1).

Les bobines de correction Bi disposées à proximité de la bobine de détection 3, sont avantageusement montées sur une structure 3' cylindrique creuse, englobant ladite bobine de détection 3.

Selon une variante de réalisation de l'invention, non représentée aux dessins annexés, chaque échantillon d'analyse Ei est muni d'une bobine de détection propre, reliée aux modules de mesure et d'acquisition et pouvant être sélectionnée individuellement ou par groupes..

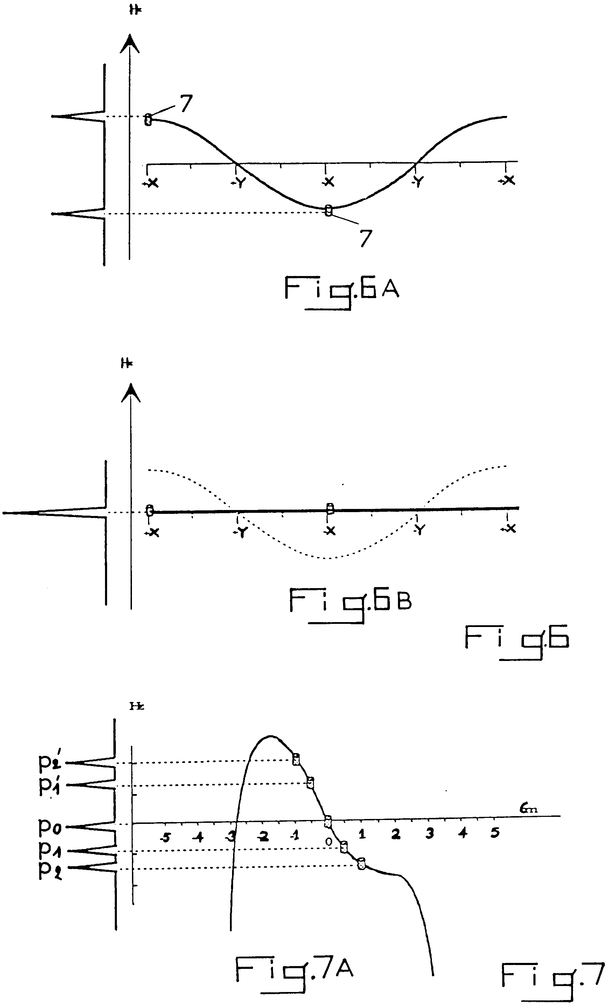

Comme le montrent les figures 5A à 5D, les échantillons d'analyse Ei sont avantageusement constitués de très faibles volumes 7 d'eau, de fluor ou d'un produit fluoré disposés dans des contenants amagnétiques 7'.

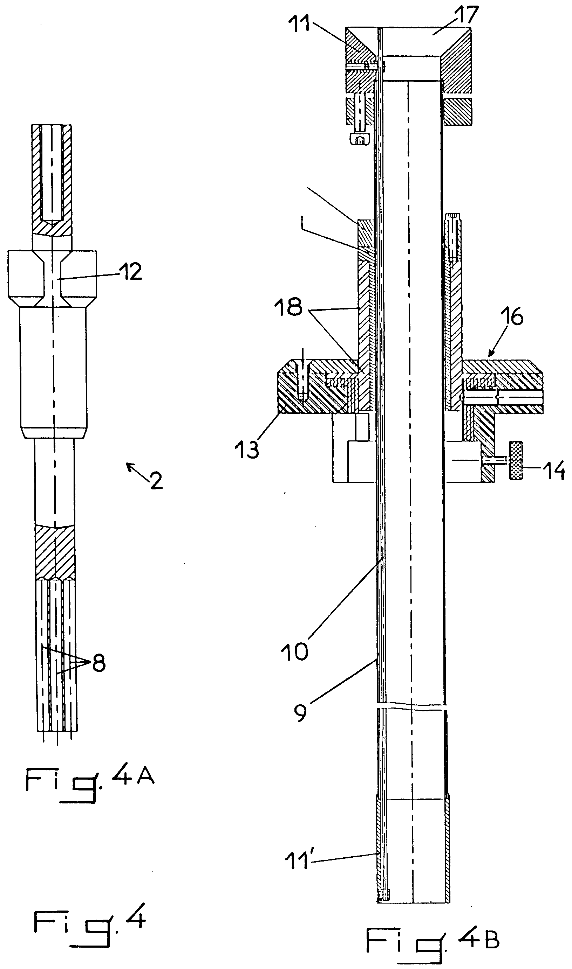

Selon un mode de réalisation préféré de l'invention, représenté à la figure 4 des dessins annexés, le porte-échantillons 2 se présente sous la forme d'un corps cylindrique ayant une section identique à celle du volume d'analyse V et comportant, à des emplacements déterminés, des évidements longitudinaux 8 pour la réception des échantillons d'analyse Ei.

Les échantillons d'analyse peuvent alors consister en des tubes 7' de matériau amagnétique contenant chacun un ou plusieurs volumes 7 d'eau à des emplacements longitudinaux donnés, de telle manière que, après introduction du ou desdits tubes 7' dans le ou les évidements 8 correspondant du porte-échantillons 2, et installation de ce dernier au niveau du volume d'analyse V à rendre homogène, lesdits volumes d'eau 7 soient positionnés aux endroits où l'action de la bobine de correction Bi à régler est prédominante, d'une part, et symétrique et/ou opposée, d'autre part (Fig. 5A à 5D).

Comme le montrent les figures 3, certains des ensembles d'échantillons Ei présentent des dispositions des volumes d'eau 7 similaires et ne se différencie que par une rotation de 90°, 45° ou 30°, selon les cas, autour de l'axe Z (Comparer par exemple entre elles les figures: 3C et 3D; 3E et 3F; 3G et 3H; 3I et 3J; 3K et 3L).

Ainsi, la prévision d'un dispositif de rotation contrôlée du porte-échantillons 2 simplifie grandement les manipulations liées à la mise en oeuvre du procédé conforme à l'invention.

Conformément à une caractéristique supplémentaire de l'invention, représentée notamment aux figures 1 et 4B des dessins annexés, le guide de positionnement 2' est principalement constitué, d'une part, par un tube 9 creux muni d'une nervure de positionnement interne 10, le cas échéant sous la forme d'une tige transversante maintenue de manière rigide aux deux extrémités dudit tube 9, au niveau de pièces de centrage 11, 11' dudit tube 9, assurant le positionnement en rotation du porte-échantillon 2 en coopérant avec une rainure 12 correspondante de ce dernier, et, d'autre part, par une embase 13 annulaire disposée autour du tube 9 et comportant des moyens 14 d'assujettissement amovible à l'orifice central 15 de la structure 3' supportant les bobines de correction Bi, ladite embase 13 comprenant également un mécanisme 16 de positionnement indexé en rotation du tube 9 par rapport à ladite structure 3'.

La pièce de centrage 11 présente avantageusement un orifice 17 traversant de forme tronconique, facilitant l'insertion du porte-échantillon 2 dans le tube creux 9 et la pièce de centrage 11', en forme de manchon, assure le centrage dudit tube creux 9 dans l'orifice central 15 de la structure 3' supportant les bobines de correction.

Après mise en place du guide de positionnement 2' dans l'appareil à RMN, l'embase 13 repose sur la structure 3' avec laquelle elle est solidarisée par l'intermédiaire, par exemple, d'une ou de plusieurs vis moletées 14.

Enfin, comme le montre également la figure 4B, le mécanisme 16 peut être composé essentiellement d'un manchon 18 de préhension, solidaire du tube creux 9 et déplaçable en rotation par rapport à l'embase 13, coopérant avec un dispositif d'encliquetage réalisant un blocage en rotation amovible dudit manchon 18 à intervales angulaires réguliers, par exemple par pas de 15°.

Grâce à l'invention, il est donc possible de rendre visible, d'une manière sélective, chaque gradient Gi pouvant être corrigés par les bobines de correction Bi et d'aboutir à leur compensation de façon consécutive et progressive, en visualisant sous forme graphique aisément compréhensible par l'opérateur et en temps réel, les variations au niveau du gradient Gi concerné en fonction d'une modification donnée de la bobine de correction Bi correspondante.

Bien entendu, l'invention n'est pas limitée au mode de réalisation décrit et représenté aux dessins annexés. Des modifications restent possibles, notamment du point de vue de la constitution des divers éléments, ou par substitution d'équivalents techniques, sans sortir pour autant du domaine de protection de l'invention.

**Revendications**

1. Procédé de mesure et d'ajustement des gradients d'un appareil à RMN, en vue de l'obtention d'un volume d'analyse magnétiquement homogène, caractérisé en ce qu'il consiste, essentiellement, à mettre en place sélectivement un ensemble d'échantillons d'analyse (Ei) ou à sélectionner de tels échantillons (Ei) déjà installés, aux endroits où l'action de la bobine de correction (Bi) à ajuster ou de la pièce ferromagnétique correspondante, pour un gradient de champ (Gi) donné, est, d'une part, prédominante et, d'autre part, symétrique et/ou opposée, à alimenter sélectivement ladite bobine de correction (Bi) à ajuster, ainsi que, le cas échéant, les bobines de correction déjà ajustées ou à mettre en place la pièce ferromagnétique correspondante, à relever le signal RMN desdits échantillons d'analyse (Ei), à visualiser ledit signal, après transformation, dans le domaine des fréquences, à régler le courant d'alimentation de la bobine de correction (Bi) à ajuster, ou à faire varier le nombre d'éléments constitutifs et/ou le positionnement de la pièce ferromagnétique correspondante, en observant, en temps réel, l'évolution du spectre fréquentiel du signal RMN desdits échantillons d'analyse (Ei) jusqu'à obtenir une configuration du spectre correspondant à une compensation totale du gradient (Gi) influencé par ladite bobine de correction (Bi) ou ladite pièce ferromagnétique, et, enfin, à effectuer ces opérations pour l'ensemble des bobines de correction ou des pièces ferromagnétiques correspondantes, selon un ordre prédéterminé fonction notamment de la configuration du volume d'analyse (V) magnétiquement homogène à obtenir.

2. Procédé selon la revendication 1, caractérisé en ce qu'il consiste, pour un volume d'analyse (V) cylindrique, à effectuer un découpage dudit volume d'analyse (V) en tenant compte de l'emplacement des bobines de correction (Bi), par l'intermédiaire d'un nombre impair de sections transversales régulièrement espacées définissant autant de plans de correction (P, Pc) pouvant recevoir des échantillons d'analyse (Ei), le point d'intersection (O) du plan de correction central (Pc) avec l'axe longitudinal (Z) dudit volume d'analyse (V) étant confondu avec le centre d'action commun de l'ensemble des bobines de correction, de la bobine de détection (3) et de l'aimant principal (1) et les plans de correction (P) extrêmes délimitant longitudinalement le volume d'analyse (V).

3. Procédé selon la revendication 2, caractérisé en ce que les échantillons d'analyse (Ei) de faible dimension, sont disposés, en fonction des bobines de correction (Bi) à régler, soit sur l'enveloppe du volume d'analyse (V) cylindrique, au niveau d'un ou de plusieurs plans de correction (P, Pc) et de manière régulièrement espacés, soit au niveau des points d'intersection desdits plans de correction (P, Pc) avec l'axe longitudinal (Z).

4. Procédé selon l'une quelconque des revendications 1 à 3, caractérisé en ce qu'il consiste, préalablement à leur ajustement, à aligner précisément entre elles, deux à deux, les bobines de correction (Bi), celles montées dans la structure de l'aimant principal (1) et celles disposées directement autour de la bobine de détection (3), devant agir dans la même direction, le réglage des bobines de correction montées dans la structure de l'aimant principal étant opéré avant celui des bobines de correction disposées autour de la bobine de détection (3).

5. Procédé selon l'une quelconque des revendications 2 à 4, caractérisé en ce qu'il consiste à régler successivement d'abord les bobines de correction [B(X), B(Y), B($X^2$ - $Y^2$), B(XY), B($X^3$), B($Y^3$)] agissant au niveau du plan de correction central (Pc), puis les bobines de correction [B($Z^1$), B($Z^2$), B($Z^3$) et B($Z^4$)] agissant le long de l'axe longitudinal (Z), et, enfin, les bobines de correction [B(ZX), B(ZY),B($Z^2$X), B($Z^2$Y), B(Z($X^2$ - $Y^2$)), B(ZXY)] agissant au niveau des autres plans de correction (P).

6. Procédé selon l'une quelconque des revendications 1 à 5, caractérisé en ce que le réglage des bobines de correction (Bi) induisant les gradients (Gi) à action prédominante, est effectué prioritairement.

7. Procédé selon l'une quelconque des revendications 2 à 6, caractérisé en ce qu'il consiste à autoriser l'existence d'un gradient [G($Z^1$)] et, le cas échéant, à dérègler la bobine de correction [B($Z^1$)] dont l'action est prédominante selon l'axe longitudinal (Z) afin d'autoriser une visualisation et un réglage aisés des actions des autres bobines de correction [B($Z^2$, $Z^3$, $Z^4$)] agissant selon l'axe longitudinal (Z) et des bobines de correction [B(ZX), B(ZY), B($Z^2$X), B($Z^2$Y), B(Z($X^2$ - $Y^2$)), B(ZXY)] agissant au niveau des plans de correction (P) autres que le plan de correction central (Pc).

8. Dispositif de mesure et de réglage pour la mise en oeuvre du procédé de mesure et d'ajustement selon l'une quelconque des revendications 1 à 7, caractérisé en ce qu'il est principalement constitué, d'une part, par des ensembles d'échantillons d'analyse (Ei) de faible dimension, montés dans la structure d'un aimant principal (1) d'un appareil à RMN ou mis en place à l'aide d'un porte-échantillon (2) coopérant avec un guide de positionnement (2') au niveau de la bobine de détection (3) de l'appareil à RMN, d'autre part, par des unités (4, 5) de mesure, d'acquisition, de transformation et de visualisation du signal RMN émis par l'ensemble d'échantillons d'analyse (Ei) sélectionnés et, enfin, par un module (6) de sélection et d'alimentation réglable des bobines de correction (Bi) à ajuster et un module de sélection des bobines de correction montées dans la structure de l'aimant principal (1).

9. Dispositif selon la revendication 8, caractérisé en ce que chaque échantillon d'analyse (Ei) est muni d'une bobine de détection propre, reliée aux unités (4) de mesure et d'acquisition et pouvant être sélectionnée individuellement ou par groupes.

10. Dispositif selon l'une quelconque des revendications 8 et 9, caractérisé en ce que les échantillons d'analyse (Ei) sont constitués de très faibles volumes (7) d'eau, de fluor ou d'un produit fluoré disposés dans des contenants amagnétiques (7').

11. Dispositif selon l'une quelconque des revendications 8 à 10, caractérisé en ce que le porte-échantillons (2) se présente sous la forme d'un corps cylindrique ayant une section identique à celle du volume d'analyse (V) et comportant, à des emplacements déterminés, des évidements longitudinaux (8) pour la réception des échantillons d'analyse (Ei).

12. Dispositif selon la revendication 11, caractérisé en ce que les ensembles d'échantillons d'analyse (Ei) sont formés à partir de tubes (7') de matériau amagnétique contenant chacun un ou plusieurs volumes (7) d'eau à des emplacements longitudinaux donnés, de telle manière que, après introduction du ou desdits tubes (7') dans le ou les évidements (8) correspondant du porte-échantillon (2), et installation de ce dernier au niveau du volume d'analyse (V) à rendre homogène, lesdits volumes d'eau (7) soient positionnés aux endroits où l'action de la bobine de correction (Bi) à régler est prédominante, d'une part, et symétrique et/ou opposée, d'autre part.

13. Dispositif selon l'une quelconque des revendications 8 à 12, caractérisé en ce que le guide de positionnement (2') est principalement constitué, d'une part, par un tube (9) creux muni d'une nervure de positionnement interne (10), le cas échéant sous la forme d'une tige traversante maintenue de manière rigide aux deux extrémités dudit tube (9), au niveau de pièces de centrage (11, 11') dudit tube (9), assurant le positionnement en rotation du porte-échantillon (2) en coopérant avec une rainure (12) correspondante de ce dernier, et, d'autre part, par une embase (13) annulaire disposée autour du tube (9) et comportant des moyens (14) d'assujettissement amovible à l'orifice central (15) de la structure (3)' supportant les bobines de correction (Bi), ladite embase (13) comprenant également un mécanisme (16) de positionnement indexé en rotation du tube (9) par rapport à ladite structure (3').

Fig.1

Fig. 2

Fig.5A    Fig.5B    Fig.5C    Fig.5D

Fig.5

Fig.3A

Fig.3B

Fig.3C

Fig.3D

Fig.3E

Fig.3F

Fig.3

Fig.3G

Fig.3H

Fig.3I

Fig.3J

Fig.3K

Fig.3

Fig.3L

Fig. 4A

Fig. 4

Fig. 4B

Fig.6A

Fig.6B

Fig.6

Fig.7A

Fig.7

Fig.7B

Fig.7C

Fig.7D

Fig.7

Fig.8B

Fig.8C

Fig.8D

Fig.8

Fig.8D

Fig.8

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.6) |
|---|---|---|---|
| Y | FR-A-2 567 648 (ELSCINT LTD.)<br>* page 2, ligne 8 - page 4, ligne 6 *<br>* page 5, ligne 26 - page 8, ligne 31; figures 1-4 * | 1,6,8-10 | G01R33/24<br>G01R33/3873<br>G01R33/3875 |
| A |  | 2,3,11, 12 | |
| Y | MAGNETIC RESONANCE IN MEDICINE.<br>vol. 6, no. 4 , 1 Avril 1988 , DULUTH,MN US<br>pages 459 - 473<br>L. BRATEMAN ET AL. 'MAGNETIC FIELD SHIMMING BY FOURIER ANALYSIS'<br>* le document en entier * | 1,6,8-10 | |
| A | PATENT ABSTRACTS OF JAPAN<br>vol. 11, no. 126 (P-569)(2573) 21 Avril 1987<br>& JP-A-61 269 049 (MITSUBISHI ELECTRIC CORP.) 29 Novembre 1986<br>* abrégé * | 1,6,8-10 | |
| A | WO-A-88 00340 (THOMSON-CGR)<br><br>* page 2, ligne 19 - page 5, ligne 11; figures 1,4 * | 1-3,6, 8-11 | **DOMAINES TECHNIQUES RECHERCHES (Int.Cl.6)**<br><br>G01R |
| A | EP-A-0 219 013 (GENERAL ELECTRIC COMPANY)<br><br>* colonne 1, ligne 4 - colonne 7, ligne 47; figure * | 1-3,6, 8-11 | |
| A | EP-A-0 241 351 (THOMSON-CGR)<br><br>* abrégé *<br>* colonne 1, ligne 16 - colonne 2, ligne 15; figures 1A,1B * | 1,8, 11-13 | |

-/--

Le présent rapport a été établi pour toutes les revendications

| Lieu de la recherche | Date d'achèvement de la recherche | Examinateur |
|---|---|---|
| LA HAYE | 20 Janvier 1994 | Horak, G |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.6) |
|---|---|---|---|
| A | US-A-4 987 371 (G.H. GLOVER ET AL.) <br> * colonne 1, ligne 65 - colonne 2, ligne 43 * <br> * colonne 3, ligne 29 - colonne 5, ligne 4 * <br> --- | 1,8 | |
| A | EP-A-0 431 848 (GENERAL ELECTRIC COMPANY) <br> * page 2, ligne 1 - page 3, ligne 58; figure 1 * <br> ----- | 1 | |
| | | | **DOMAINES TECHNIQUES RECHERCHES (Int.Cl.6)** |

Le présent rapport a été établi pour toutes les revendications

| Lieu de la recherche | Date d'achèvement de la recherche | Examinateur |
|---|---|---|
| LA HAYE | 20 Janvier 1994 | Horak, G |

**CATEGORIE DES DOCUMENTS CITES**

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
...........................................................................................
& : membre de la même famille, document correspondant

EPO FORM 1503 03.82 (P04C02)